(19) **Europäisches Patentamt / European Patent Office / Office européen des brevets**

(11) **EP 4 530 650 B1**

(12) **EUROPEAN PATENT SPECIFICATION**

(45) Date of publication and mention of the grant of the patent:
**13.05.2026   Bulletin 2026/20**

(21) Application number: **24202592.2**

(22) Date of filing: **25.09.2024**

(51) International Patent Classification (IPC):
**G01R 31/367** (2019.01)    **G01R 31/392** (2019.01)
**G01R 31/396** (2019.01)

(52) Cooperative Patent Classification (CPC):
**G01R 31/367; G01R 31/392; G01R 31/396;**
**H01M 2220/20**

(54) **METHOD AND APPARATUS FOR ESTIMATION AND VISUALIZATION OF CONSISTENCY FOR POWER BATTERY**

VERFAHREN UND VORRICHTUNG ZUR SCHÄTZUNG UND VISUALISIERUNG DER KONSISTENZ EINER LEISTUNGSBATTERIE

PROCÉDÉ ET APPAREIL D'ESTIMATION ET DE VISUALISATION DE COHÉRENCE POUR BATTERIE D'ALIMENTATION

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**

(30) Priority:  **27.09.2023   CN 202311270478**

(43) Date of publication of application:
**02.04.2025   Bulletin 2025/14**

(73) Proprietor: **Volvo Car Corporation**
**405 31 Göteborg (SE)**

(72) Inventors:
• **KAN, Yuyan**
**Shanghai (CN)**
• **WANG, Enqun**
**Shanghai (CN)**
• **FANG, Xin**
**Shanghai (CN)**
• **SHEN, Bin**
**Shanghai (CN)**

(74) Representative: **Kransell & Wennborg KB**
**P.O. Box 2096**
**403 12 Göteborg (SE)**

(56) References cited:
**CN-A- 102 540 098     CN-A- 110 221 226**
**CN-A- 112 485 695**

# Description

## TECHNICAL FIELD

The present invention relates to the field of electric automobiles, and more particularly, to a method and an apparatus for estimation and visualization of consistency for power battery.

## BACKGROUND

With the increasingly serious global environmental and energy problems, new energy automobiles have attracted a wide attention because of their advantages such as energy saving, high efficiency, low carbon and environmental friendliness. In recent years, a rapid rise of the industry of electric automobiles such as pure electric automobiles and hybrid electric automobiles has become an inevitable trend of the development of automobile industry. However, there are still some problems to be urgently solved in the field of electric automobile application technology.

The document CN 102 540 098 A discloses a data collection method for a battery pack. The method involves obtaining datasets for use in the determination of a battery operating in a vehicle. To this end the respective voltage of each cell is measured and the ensuing voltage dataset is digitally filtered to suppress noise.

Power battery, which is one of the core components of electric automobiles, takes responsibility for storing and releasing electric energy for providing a vehicle with energy for driving and other vehicle applications, that is, power battery is used as a power supply for the vehicle. Taking the existing Li-ion battery as an example, the power battery is usually a battery pack composed of a plurality of monomer cells in series and/or in parallel. However, since the monomer cells can be affected during the production by various factors such as technological or environmental factors, there are inevitably differences among respective cells in terms of such as internal resistance, capacity, State of Charge (SOC) and the like, and such differences can be further aggravated during the use of battery, resulting in that the performances among the cells fail to be completely consistent, that is, inconsistency for power battery. Disadvantageously, such inconsistency can lead to problems such as reduction in vehicle's endurance mileage, damage to battery pack health and the like, and eventually incur decline in reliability of power battery and even premature failure. Therefore, in order to guarantee the delivery of a high-quality vehicle to the user, it is necessary to accurately estimate and evaluate the consistency for power battery in the early testing stage for vehicles.

In view of the above, there is a need for an improved estimation method and visualization method for consistency for power battery, and an apparatus for implementing the above method.

## SUMMARY

According to one aspect of the present disclosure, there is provided a method for estimation of consistency for power battery, including: detecting operating voltages for each cell of a plurality of cells in real time during an operation period of a vehicle to obtain a first voltage dataset for the each cell; performing a first filtering process on the first voltage dataset to retain voltage data corresponding to operating currents less than a first threshold, such that a filtered second voltage dataset for the each cell is obtained; calculating an energy score for the each cell based on the second voltage dataset; and calculating a first consistency score for the power battery based on the calculated energy score for the each cell.

According to an embodiment of the present disclosure, the obtaining a filtered second voltage dataset for the each cell further includes: performing a second filtering process on the first voltage dataset to retain voltage data corresponding to a specific section of state of charge (SOC).

According to an embodiment of the present disclosure, the calculating an energy score for the each cell includes: transforming the second voltage dataset into a frequency domain dataset with amplitude; and calculating the energy score for the each cell based on corresponding amplitudes of low-frequency components in the frequency domain dataset.

According to an embodiment of the present disclosure, the calculating a first consistency score for the power battery includes: performing a normalizing process on the calculated energy score for the each cell; determining a limit value according to statistical data of historical energy score, the limit value including at least one of an upper limit value and a lower limit value of the energy score; determining an energy score exceeding the limit value by a second threshold as an outlier; and calculating an Euclidean distance between the outlier and the exceeded limit value as the first consistency score, in which the calculating the first consistency score for the power battery further includes: performing, using a principal component analysis (PCA) method, a data dimension reduction process on the Euclidean distance of the outlier and an additional parameter during the operation period, and determining a value obtained by the data dimension reduction as the first consistency score; or calculating, using a machine learning-based model, the first consistency score for the power battery based on the Euclidean distance of the outlier and an additional parameter during the operation period; in which the additional parameter is selected from a group consisting of: state of charge (SOC) of the power battery, usage time of the power battery, temperature of the power battery, resistance of the power battery, and current mileage of the vehicle.

According to another aspect of the present disclosure, there is provided a method for visualization of consistency for power battery, including: providing a first visualized representation of the energy score for the each cell as a function of a specific variable, based on the energy score calculated by the above method for estimating consistency for power battery; in which the specific variable is a variable related to mileage of the vehicle or usage time of the power battery.

According to an embodiment of the present disclosure, the method for visualization further includes: displaying a first decision line in the first visualized representation, wherein the first decision line is determined according to statistical data of historical energy score; and indicating a cell corresponding to a function exceeding the first decision line by a third threshold as an abnormal cell.

According to another aspect of the present disclosure, there is provided a method for estimating vehicle level-based consistency for power battery, including: calculating, according to the above method for estimating consistency for power battery and for each vehicle of a plurality of vehicles using the same power batteries, the first consistency score for the power battery of the each vehicle, respectively; and calculating a vehicle level-based second consistency score for power battery based on the first consistency score for the power battery of the each vehicle.

According to another aspect of the present disclosure, there is provided a method for visualization of vehicle level-based consistency for power battery, including: providing a second visualized representation of the first consistency score for the power battery of the each vehicle as a function of a specific variable based on the first consistency score for the power battery of the each vehicle calculated according to the above method for estimating consistency for power battery; in which the specific variable is a variable related to mileage of the each vehicle or usage time of the power battery of the each vehicle.

According to an embodiment of the present disclosure, the method for visualization further includes: displaying a second decision line in the second visualized representation, wherein the second decision line is determined according to statistical data of historical second consistency score; and indicating a vehicle corresponding to a function exceeding the second decision line by a fourth threshold as an abnormal vehicle.

According to another aspect of the present disclosure, there is provided an apparatus for estimating vehicle level-based consistency for power battery, including: a processor and a memory having stored computer program instructions thereon, in which the computer program instructions, when executed by the processor, cause the processor to perform the above method for estimating consistency for power battery.

According to an embodiment of the present disclosure, the apparatus further includes a device for visualizing the consistency for power battery, the device being configured to provide the above first visualized representation for the energy score for the each cell and the above second visualized representation for the first consistency score for the power battery of the each vehicle.

Based on the above, the method for estimation of consistency for power battery according to the present disclosure can monitor the consistency for power battery in real time during the operation period of a vehicle, and can evaluate the consistency for power battery with a more accurate method, thus providing a more efficient and accurate method for estimation of consistency for power battery. Additionally, the method for visualization of consistency for power battery according to the present disclosure can provide visualized charts related to the consistency for power battery to the testing personnel or user of the vehicle in real time, so that the personnel can understand the performance of the vehicle more intuitively, thereby contributing to work such as test as well as check and acceptance for the power battery of the vehicle.

## BRIEF DESCRIPTION OF DRAWINGS

These and/or other aspects and advantages of the present disclosure will become clearer and easier to be understood, from the following detailed description of the embodiments of the present disclosure, taken in conjunction with the accompanying drawings, in which:

Fig. 1 shows a flowchart of an method for estimation of consistency for power battery according to an embodiment of the present disclosure;
Fig. 2 shows a schematic diagram of visualization for consistency for power battery according to an embodiment of the present disclosure;
Fig. 3 shows a schematic diagram of visualization for vehicle level-based consistency for power battery according to an embodiment of the present disclosure;
Fig. 4 shows another schematic diagram of visualization for vehicle level-based consistency for power battery according to an embodiment of the present disclosure;
Fig. 5 shows yet another schematic diagram of visualization for vehicle level-based consistency for power battery according to an embodiment of the present disclosure; and
Fig. 6 is a block diagram showing an example of an apparatus for estimating consistency for power battery according to an embodiment of the present disclosure.

It should be understood that these accompanying drawings are used to provide a further understanding of the embodiments of the present invention, constitute a part of the specification, and together with the embodiments of the present invention, serve to explain the present invention, but do not constitute a limitation of the present invention. In addition, in the accompanying drawings, like reference numerals generally represent like parts or steps.

DETAILED DESCRIPTION

In order to better set forth the technical scheme of the present disclosure, the present disclosure will be further illustrated in detail below in conjunction with the accompanying drawings and specific embodiments. It should be understood that based on the embodiments described in the present invention, all other embodiments obtained by those skilled in the art without creative labor should fall within the protection scope of the present invention, and the embodiments described herein are only parts of the embodiments of the present invention, not all the embodiments of the present invention. These embodiments are merely illustrative and exemplary, and thus should not be interpreted as limiting the scope of the present invention.

In the following, for the purpose of illustration rather than limitation, the present disclosure will mainly take the power battery of electric automobile as an example to set forth the technical scheme of the present disclosure. The electric automobiles herein can broadly refer to the vehicles that at least partially use electric energy as power, and can include pure electric automobiles and hybrid electric automobiles, for example.

First of all, the overall technical concept and involved terminologies of the present disclosure are illustrated.

As previously mentioned, performance metric of power battery includes state of charge (SOC), and this parameter can usually be expressed as a ratio of currently available remaining capacity of the power battery to its full charge capacity after being fully charged. Therefore, in some scenarios, the SOC can also be simply regarded as the "remaining power" of the vehicle. Then, the user of the vehicle (such as the driver or passenger) can decide, according to the information related to SOC, whether to replenish energy for the vehicle and a corresponding driving strategy. For this reason, it is vital for the driving and using of the vehicle to provide the user with the SOC regarding the power battery or its related parameters in real time. Moreover, the consistency for the SOCs among cells is also a key factor affecting the performance and service life of the power battery, therefore, it is necessary to accurately estimate the parameters related to SOC.

At present, the existing SOC estimation methods usually employ an Open Circuit Voltage (OCV)-based method, whose principle is to determine an SOC value of a battery according to its detected OCV value. Taking a monomer cell as an example, for example, the voltage can reach about 4V when it is fully charged (SOC is about 100%), whereas the voltage is about 2.4V when it is fully discharged (SOC is about 0%). According to this, the OCV values corresponding to a cell under different SOC values can be detected respectively, and then a curve for SOC-OCV can be obtained by a data fitting method. However, due to the influence from the heat generated by the battery during the use and the polarization effect by the battery, the voltage of the battery is led to be not stable for a period of time after the battery stops charging and discharging, resulting in that in the existing OCV-based SOC estimation, an available OCV value can be obtained only after the battery has stood for several hours after the use. Therefore, the existing OCV-based estimation method usually measures the OCV value of the power battery/cell when the vehicle is not operating (e.g., during the stall of the vehicle at night), so that the OCV data obtained in such manner is very limited and also off-line, and correspondingly, the obtained curve for SOC-OCV is inaccurate, which makes it difficult to reflect the current real power information of power battery to the user in real time, and is not conducive to accurate estimation of the consistency for power battery. In addition, this method is usually very time-consuming since the detecting of OCV value requires the power battery to stand for a period of time after each charge and discharge so as to wait for the voltage to be stable.

In view of this, the present disclosure proposes a method for estimation of consistency for power battery and an apparatus for implementing the method, so as to solve the above and other problems existing in the existing methods.

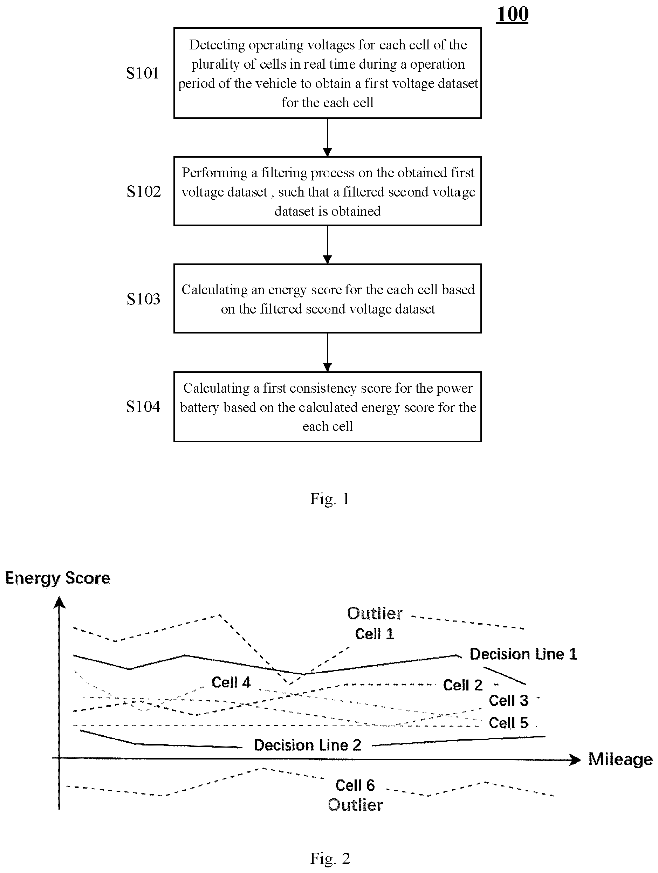

Fig. 1 shows a flowchart of a method for estimation of consistency for power battery according to an embodiment of the present disclosure. As shown in Fig. 1, an example method 100 of the present disclosure may include the following steps:
In step S101, operating voltages for each cell of the plurality of cells are detected in real time during the operation period of the vehicle to obtain a first voltage dataset for the each cell.

Specifically, being during the operation period of the vehicle refers to an operating state where the vehicle is in after it is started, for example, the vehicle is moving, is being charged, or is in a state where the vehicle stops but does not stall/power off. In such a state, the power battery of the vehicle is in a corresponding operating state and has a corresponding operating voltage/current. During the operation period of the vehicle, a current operating voltage of the each cell in the power battery, such as the discharging voltage when the power battery is being discharged or the charging voltage when the power battery is being charged, may be detected/measured/read (or other means of obtaining the voltage directly or indirectly) in real time through a detection device such as sensor or any other suitable types of devices, thereby obtaining a set of voltage values of the each cell in continuous time series as the first voltage dataset for further analysis and processing.

According to the embodiment of the present disclosure, depending on a corresponding application scenario, a corresponding time interval and cycle may be selected for detecting the voltage data of the cell, and an amount (such as size and/or quantity) of detected voltage data may be selected. For example, for a case where the vehicle's state or environmental parameters are relatively stable, a relatively large time interval may be selected to guarantee the stability and accuracy of data, and for a case where the vehicle and environment is relatively complex or dynamically changes at any time, a relatively small time interval may be selected to guarantee the sensitivity of data and avoid the loss of details. In addition, an amount of data required to be detected within one cycle may be determined by weighing factors such as calculation amount of data, storage cost, performance requirements, etc.

In step S102, a filtering process is performed on the obtained first voltage dataset, thereby obtaining a filtered second voltage dataset.

Specifically, after obtaining a plurality of voltage data as the first voltage dataset, these data are filtered by means of a filtering process so as to obtain more effective voltage data.

For example, according to the embodiment of the present disclosure, a first filtering process is performed on the first voltage dataset to retain voltage data corresponding to operating currents less than a first threshold. Specifically, when the value of operating current of the power battery of the vehicle is small, for example, the vehicle currently might be in a state of low speed, stopping or low power, and the heating and other adverse influences caused by the power battery due to internal resistance are also at an extremely low level, in this case, the corresponding voltage data obtained in a real-time manner can also have high stability and accuracy. Based on the above, the above embodiment of the present disclosure can filter the obtained voltage data by limiting a current whose charging/discharging rate is less than a specific numerical value (e.g., 0.1), so as to retain voltage data corresponding to a small operating current. In this way, the feasibility of battery consistency estimation utilizing real-time detected operating voltage is realized.

In addition, as described above, due to factors such as the polarization effect by the power battery, the voltage data is led to have good stability only in a specific section of SOC (such as 30% to 80%), and thus to have good correlation with SOC. Therefore, according to another embodiment of the present disclosure, a second filtering process may be also performed on the first voltage dataset, that is, the detected voltage data may be filtered by limiting the range of SOC, so as to retain the voltage data corresponding to the specific section of state of charge (SOC).

It can be seen that the detected real-time data can be optimized through the above first filtering process and the second filtering process, so that the optimized real-time voltage data contributes to more accurate estimation of state of battery. Additionally, the order of the above filtering process is not particularly limited, and the detected voltage data may be filtered in a parallel manner.

In step S103, the energy score for the each cell is calculated based on the filtered second voltage dataset.

Specifically, through the above steps, the detection and collection of the operating voltages of the each cell in the power battery is realized, and a filtered second voltage dataset is obtained, which is a set of voltage data in time series and corresponds to the detected voltage values for the each cell in a specific time period. As described above, the voltage value of a battery/cell may be related to the SOC and other performance metrics of the battery/cell, so the second voltage dataset may be used to calculate the score indicating the operating condition of the each cell.

In order to quantify the operating condition of the each cell in the power battery, according to the embodiment of the present disclosure, the following operations may be performed: first, the second voltage dataset is transformed into a discrete dataset in frequency domain by such as discrete Fourier transform (DFT), in which the discrete dataset is composed of a set of discrete frequency domain data with corresponding amplitudes. For example, taking cell 1 in the power battery as an example, through the above steps, 100 voltage data ($V_{t1}$, $V_{t2}$, ..., $V_{t100}$) are collected in time series as the second voltage dataset, and the second voltage dataset is transformed into a set of 100 frequency-domain data ($V_{f1}$, $V_{f2}$, ..., $V_{f100}$) with corresponding amplitudes ($A_1$, $A_2$, ..., $A_{100}$) by DFT. Then, the high-frequency components that are possibly noise data are filtered out by an appropriate filter (e.g., the components with frequencies higher than a certain threshold are filtered out), and accordingly, the low-frequency components in the frequency-domain dataset are obtained for subsequent processing. For example, 25 frequency domain data with the lowest frequencies among the filtered low-frequency components are selected, and their corresponding amplitudes are used to calculate the energy score for the cell 1 so as to indicate the operating condition of the cell1. For example, according to a preferred embodiment of the present disclosure, the amplitudes of these frequency domain data can be squared and then added ($A_1^2+A_2^2+A_3^2+...+A_{25}^2$) as the energy score for the cell 1. It should be noted that the calculation of energy score is not limited to the above manner, for example, the amplitudes of multiple frequency components or the voltage data in time domain can be simply added, or their average value can be calculated, and so on. Similarly, the energy score for the each cell in the power battery can be calculated in this way.

In step S104, a first consistency score for the power battery is calculated based on the calculated energy score for the each cell.

Specifically, through the above steps, the energy score for the each cell in the power battery is calculated based on the voltage data detected in real time during the operation period of the vehicle, and on this basis, the differences in energy scores among the cells may be further compared to estimate the consistency for power battery.

In order to quantify the operating condition of the each cell in the power battery, according to the embodiment of the present disclosure, the following operations may be performed: firstly, a normalization process is performed on the energy score for the each cell. Specifically, since the voltage data detected in real time might be obtained under various conditions (e.g., the above filtering conditions), the range of the voltage data under various conditions is unified into a limited section through the normalization process, so as to avoid adverse influences on the overall evaluation result caused by excessive numerical differences under different conditions, so that the performance and stability of the evaluation model is high. Additionally, a limit value is determined according to the statistical data of historical energy score. For example, according to sufficient historical test data and/or usage data collected for the power batteries of the same model, an upper limit value and a lower limit value of the energy score corresponding to a cell in a normal operating range can be determined, so that an energy score exceeding the upper limit value or the lower limit value can be determined as an outlier, and a cell corresponding to the outlier is an abnormal cell. For example, the statistical data of historical energy score is expressed in a quartile manner, and the maximum value ($Q_{max}$) and the minimum value ($Q_{min}$) of the quartile are taken as the above limit values. And in order to guarantee the rigor of data, an energy score exceeding $Q_{max}$ or $Q_{min}$ by a certain threshold can be determined as an outlier (X), that is, the range of limit values is appropriately increased. For example, $Q_{max}$ or $Q_{min}$ of a traditional quartile can be expressed as quartile distance (IQR) +/-k*IQR, respectively, where the parameter k=1.5. The limit value is calculated by appropriately increasing the value of k (such as 1.7) to determine the outlier more strictly. After determining the outliers in the energy scores of all the cells, an Euclidean distance between an outlier and its exceeded corresponding limit value is calculated, that is, a distance of outlier (DOO) for the power battery, which can be expressed as the following formula:

$$DOO = \sqrt{\sum_i (X_i - Q_i)^2}$$

where $X_i$ represents the i-th outlier and $Q_i$ represents the limit value which the i-th outlier exceeds.

The DOO obtained through the above calculation can indicate a difference between an outlier for a cell in the power battery and a normal value, and can be used as a score for evaluating consistency for power battery.

In addition, on the basis of the obtaining of DOO by calculation, other additional parameter during the operation period of the vehicle can be further considered to accurately evaluate the consistency for power battery with more comprehensive data. For example, the additional parameter may include one of: state of charge (SOC) of the power battery, usage time of the power battery, temperature of the power battery, resistance of the power battery, or current mileage of the vehicle.

According to an embodiment of the present disclosure, a principal component analysis (PCA) method is used to perform a data dimension reduction process on the DOO and the additional parameter during the operation period, and the value obtained by the data dimension reduction can be determined as the score for evaluating consistency for power battery. Specifically, through the method described above, a DOO of the power battery can be calculated based on the voltage dataset detected in real time, and the DOO is associated with other parameters of the vehicle in the current detection cycle, for example, the above additional parameter of the vehicle at the first time point or the last time point or another key time point in the corresponding detection cycle. Taking the SOC of the power battery as an example of the additional parameter, it serves as a two-dimensional data together with the DOO calculated in a specific detection cycle, and a two-dimensional dataset consisting of the above two parameters is collected through multiple detection cycles. A projection matrix corresponding to the principal component is constructed with the PCA method. A multiplication process is performed on the original two-dimensional data and the established projection matrix so as to project the two-dimensional data onto the principal component, thereby obtaining a dimension-reduced data, which is equivalent to a new parameter formed by a fusion of the DOO and the SOC, and can be used as a score for evaluating consistency for power battery (e.g., can be referred to as DOC).

Alternatively, according to another embodiment of the present disclosure, using a machine learning-based model, for example, a model based on machine learning algorithm such as XGBoost, random forest, logistic regression, Support Vector Machine (SVM), etc., a score for evaluating consistency for power battery is calculated based on the DOO and a plurality of other additional parameter. For example, in addition to DOO and SOC, it is also possible to consider the current mileage of the vehicle, that is, the corresponding accumulated mileage (such as 1000 kilometers) of the vehicle in the corresponding detection cycle. The above considered parameters are taken as the input features, and the consistency score is taken as the target variable. A classifier model is trained by using a training set, and the model parameters are optimized by iteration, so that a score (which can be referred to as DCM, for example) for evaluating consistency for power battery is calculated with the fusion of the DOO, SOC and mileage of the vehicle using a machine learning-based model.

Calculating a score for evaluating consistency for power battery in the above manners can compress the multi-dimensional factors affecting the power battery to make a comprehensive consideration, realizing a more comprehensive evaluation of consistency for power battery.

A method for estimation of consistency for power battery is described through various exemplary embodiments in conjunction with Fig. 1 above. Through the estimation method of the present disclosure, the consistency for power battery can be estimated by utilizing voltage data detected in real time, and the method is more efficient and accurate than the traditional method, providing important data support for performance analysis and fault diagnosis.

In addition, according to another aspect of the present disclosure, there is also provided a method for visualization of consistency for power battery, which is used for visualizing the energy score calculated according to the above estimation method, and specifically relates to providing a first visualized representation of the energy score for the each cell as a function of a specific variable, in which for example, the specific variable may be a variable related to mileage of the vehicle or usage time of the power battery.

Fig. 2 shows a schematic diagram for visualization of consistency for power battery according to an embodiment of the present disclosure.

As shown in Fig. 2, a graph of energy score as a function of vehicle's mileage is provided, in which the horizontal axis of the graph is the vehicle's mileage, indicating the accumulated distance traveled by the vehicle (e.g., in kilometers); and the vertical axis is the energy score for each cell in the power battery of the vehicle. For example, the energy score for the each cell can be calculated by the above estimation method, and the energy scores for the respective cells can be distinguished by different colors and line segment types. In an ideal state, the energy score for the each cell during the use should be consistent. In this way, the testing personnel or user of the vehicle can be provided with a fluctuation exhibited by each cell with the increase of mileage, so that it is convenient to visually view the changing trend in the consistency for power battery.

In addition, as shown in Fig. 2, one or more decision lines for defining abnormal cells may also be displayed in the above visualized representation. The decision lines are determined according to statistical data of historical energy score. For example, as described above, according to historical test data and/or usage data for power batteries, an upper limit value and a lower limit value of energy score corresponding to a cell in a normal operating range can be determined, and in turn a decision line on a corresponding mileage can be determined. Therefore, the decision lines can be composed of points corresponding to the limit values, defining a section in the normal operating range. On this basis, a cell corresponding to a function exceeding a decision line by a certain threshold (e.g., the excessive part is more than 50%, or the excessive distance is more than a certain numerical value) is indicated as an abnormal cell. For example, in Fig. 2, a part of more than 90% of the function of cell1 exceeds decision line 1 corresponding to the upper limit value, and the entirety of the function of cell6 exceeds decision line 2 corresponding to the lower limit value. Therefore, cell1 and cell6 are indicated as abnormal cells, for example, by specific colors, line segment types, text prompts and the like.

Additionally, in this field, the existing consistency for power battery is limited to be within a single vehicle or a battery pack, and the consistency for power battery is not monitored and evaluated at vehicle level, that is, in the prior art, there is no concern about whether the performance of power batteries among multiple vehicles using battery packs with the same parameters (e.g., the same battery model, the same material, or the same supplier) is consistent.

In view of this, the present disclosure also proposes to collect statistical data on consistency for battery packs of vehicles of the same model or a plurality of vehicles using the same power batteries (e.g., electric automobiles of the same model), so as to obtain an estimation of vehicle level consistency for power battery. The specific method involves using the estimation method described above in conjunction with Fig. 1, including: calculating a consistency score (which can be referred to as a first consistency score) for power battery of each vehicle of a plurality of vehicles using the same power batteries, and then calculating, based on the calculated consistency score for the power battery of the each vehicle, a consistency score for power batteries of a group composed of these vehicles, that is, a vehicle level-based consistency score for power battery (which can be referred to as a second consistency score). For example, the consistency for the power batteries of these vehicles may be estimated by comparing the differences in consistency scores for power batteries among these vehicles. For example, an average and variance or standard deviation of the consistency scores for power batteries of all the vehicles are calculated for evaluating the consistency for this group of vehicles in terms of power batteries. Additionally, the calculation method of the first consistency score and the calculation method of the vehicle level-based second consistency score may be similar, and both of them quantify the dispersion degree of data, and therefore, the above-described method can be used to apply to the calculation of both of the consistency scores, which will not be detailed here.

In addition, according to another aspect of the present disclosure, there is correspondingly provided a method for visualization of vehicle level-based consistency for power battery, which is used for visualizing the consistency score for power battery of each vehicle calculated according to the above estimation method, in particular relates to providing a second visualized representation of the first consistency score for power battery of each vehicle as a function of a specific variable, in which for example, the specific variable may be a variable related to mileage of the vehicle or usage time of the power battery.

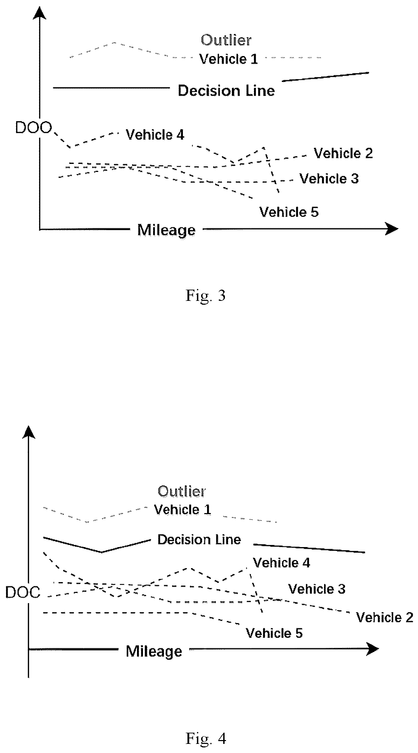

Fig. 3 shows a schematic diagram for visualization of vehicle level-based consistency for power battery according to an embodiment of the present disclosure.

As shown in Fig. 3, a graph of a first consistency score for power battery of each vehicle as a function of the vehicle's mileage is provided, in which the horizontal axis of the graph is the vehicle's mileage, indicating an accumulated distance traveled by the vehicle (e.g., in kilometers); and the vertical axis is the consistency score for each vehicle. The DOO for power battery as described above is used as the consistency score among the embodiments, and different colors and line segment types are used to distinguish the consistency scores for power batteries corresponding to respective vehicles. In an ideal state, the consistency scores for the power batteries of the vehicles using the same power batteries should be consistent. In this way, the testing personnel or user of the vehicle can be provided with a fluctuation exhibited by vehicles or vehicle group of a specific model with the increase of mileage in terms of power batteries, so that it is convenient to intuitively view the changing trend in the vehicle level-based consistency for power battery.

In addition, as shown in Fig. 3, one or more decision lines for defining abnormal vehicles may also be displayed in the above visualized representation. The decision lines are determined according to statistical data of historical consistency score for power battery. For example, as described above, according to historical test data and/or usage data for power battery, the limit value of the consistency score corresponding to power battery in a normal operating range can be determined, and in turn a decision line on a corresponding mileage can be determined. Therefore, the decision lines can be composed of points corresponding to the limit values, defining a section in the normal operating range. On this basis, a vehicle corresponding to a function exceeding a decision line by a certain threshold (e.g., the excessive part is more than 50%, or the excessive distance is more than a certain numerical value) is indicated as an abnormal vehicle. For example, in Fig. 3, vehicle 1 exceeds the decision line corresponding to the upper limit value, and thus the vehicle1 is indicated as an abnormal vehicle, for example, by a specific color, line segment type, text prompt and the like.

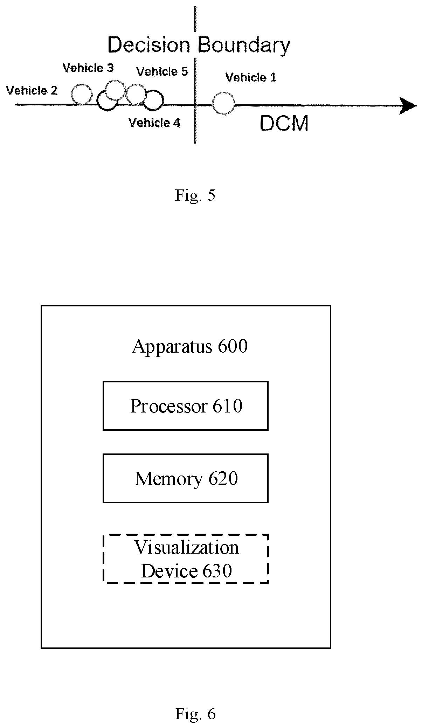

In addition, according to the embodiment of the present disclosure, the consistency score for power battery is not limited to the DOO of the above example, and may also include, for example, the consistency score calculated by a data dimension reduction process using the PCA method, or the consistency score calculated by a machine learning-based model. Figs. 4 and 5 respectively show other schematic diagrams for visualization of vehicle level-based consistency for power battery according to the embodiments of the present disclosure. Specifically, in Fig. 4, the horizontal axis is the vehicle's mileage, and the vertical axis uses the DOC for power battery as described above as the consistency score;

whereas in Fig. 5, the vehicle level-based consistency for power battery is visualized with a classification result diagram, in which the points representing the vehicles in the normal range are clustered to the left of the decision boundary (equivalent to the decision line) and the points representing the abnormal vehicles are clustered to the right of the decision boundary. In addition, according to other embodiments of the present disclosure, the calculated energy score and the consistency for power battery can also be visualized by means of such as box diagram or histogram.

A method for visualization of consistency for power battery is described through various exemplary embodiments in conjunction to Figs. 2 to 5. Through the visualization method of the present disclosure, various calculated parameters related to consistency for power battery are presented as functions of different variables, thereby providing a more intuitive presentation for consistency evaluation and facilitating the testing personnel to observe the relationships and trends among different variables. In addition, for a dataset containing multiple variables, the high-dimensional data can be compressed by visualizing the consistency score curve, thereby visually presenting the relationships among the respective parameters and contributing to the discovery of outliers.

Next, an example of an apparatus for estimating consistency for power battery according to an embodiment of the present disclosure will be described with reference to Fig. 6. Each step of the method for estimating consistency can be performed by one or more processing units or processors in an apparatus for estimating consistency for power battery, and an exemplary architecture of the apparatus is shown by Fig. 6.

As shown in Fig. 6, an apparatus 600 for estimating consistency for power battery includes: a processor 610 and a memory 620. The apparatus 600 may be a computer integrated in a vehicle or a remote server. It should be understood that the shown structure is only exemplary and not restrictive, and in addition to these units, the apparatus 600 may include other components. However, since these components are unrelated to the content of the embodiments of the present invention, their illustration and description are omitted herein.

In addition, since the specific details of the operations performed by the apparatus 600 for estimating consistency for power battery according to the embodiment of the present disclosure are roughly similar to those described above with reference to Figs. 1-5, a partial description of the same details is omitted herein for the purpose of brevity.

The processor 610 may be a central processing unit (CPU), a micro-control unit (MCU), a data signal processor (DSP), or other forms of processing units with data processing capability and/or instruction executing capability, and may utilize computer program instructions stored in the memory 620 to perform desired functions, in which the computer program instructions, when executed by the processor 610, perform the following steps for estimating consistency for power battery:

detecting operating voltages for each cell of the plurality of cells in real time during the operation period of the vehicle to obtain a first voltage dataset for the each cell; performing a first filtering process on the first voltage dataset to retain voltage data corresponding to operating currents less than a first threshold, thereby obtaining a filtered second voltage dataset for the each cell; calculating an energy score for the each cell based on the second voltage dataset; and calculating a first consistency score for the power battery based on the calculated energy score for the each cell;

performing a second filtering process on the first voltage dataset to retain voltage data corresponding to a specific section of state of charge (SOC);

transforming the second voltage dataset into a frequency domain dataset with amplitude; and calculating the energy score for the each cell based on corresponding amplitudes of low-frequency components in the frequency domain dataset;

performing a normalizing process on the calculated energy score for the each cell; determining a limit value according to statistical data of historical energy score, the limit value including at least one of an upper limit value and a lower limit value of the energy score; determining an energy score exceeding the limit value by a second threshold as an outlier; and calculating an Euclidean distance between the outlier and the exceeded limit value as the first consistency score;

performing, using a principal component analysis (PCA) method, a data dimension reduction process on the Euclidean distance of the outlier and an additional parameter during the operation period, and determining a value obtained by the data dimension reduction as the first consistency score; or calculating, using a machine learning-based model, the first consistency score for the power battery based on the Euclidean distance of the outlier and an additional parameter during the operation period; in which the additional parameter is selected from a group consisting of: state of charge (SOC) of the power battery, usage time of the power battery, temperature of the power battery, resistance of the power battery, and current mileage of the vehicle.

In addition, the computer program instructions, when executed by the processor 610, further perform the following steps for estimating vehicle level-based consistency for power battery:

for each vehicle of a plurality of vehicles using the same power batteries, calculating the first consistency score for the power battery of the each vehicle, respectively; and calculating a vehicle level-based second consistency score for power battery based on the first consistency score for the power battery of the each vehicle.

The memory 620 may include one or more computer program products, and the computer program products may include various forms of computer-readable storage media, for example, volatile memory and/or nonvolatile memory. One or more computer program instructions may be stored on a computer-readable storage medium, so that the processor 610 can execute the program instructions to implement the above functions and/or other desired functions of the embodiments of the present invention in the above, and/or can perform the above methods according to the embodiments of the present invention. Various application programs and various data may also be stored in the computer-readable storage medium.

In addition, the apparatus 600 for estimating consistency for power battery according to an embodiment of the present disclosure further includes a device 630 for visualizing the consistency for power battery, and the device is configured to: provide a visualization of the consistency for power battery described above in conjunction with Figs. 2 to 5, for example, to provide a first visualized representation of the energy score for the each cell as a function of a specific variable, and to provide a second visualized representation of the first consistency score for the power battery of the each vehicle as a function of a specific variable; in which, the specific variable is a variable related to mileage of the vehicle or usage time of the power battery; also, to display a first decision line in the first visualized representation, and indicate a cell corresponding to a function exceeding the first decision line by a third threshold as an abnormal cell; and to display a second decision line in the second visualized representation, and indicate a vehicle corresponding to a function exceeding the second decision line by a fourth threshold as an abnormal vehicle.

In addition, the apparatus for estimating consistency for power battery and the apparatus for estimating vehicle level-based consistency for power battery may be the same apparatus, or may be different apparatuses, for example, may be used as an on-board computer of a vehicle and a platform system for testing vehicles, respectively.

Next, a computer-readable storage medium according to an embodiment of the present invention will be described. The present invention also provides a computer-readable storage medium having stored computer program instructions thereon, in which the computer program instructions, when executed by a processor, implement the steps performed by the processor as described above, which are consistent with the corresponding contents of various embodiments described above in conjunction with Figs. 1-6. In addition, it should be understood that various components or modules in the above apparatus may be implemented by hardware, or may be implemented by software, and may also be implemented by a combination of hardware and software.

The method and apparatus for estimation and visualization of consistency for power battery according to the embodiments of the present disclosure have been fully described above in conjunction with various accompanying drawings. By means of various aspects and embodiments of the present disclosure, the consistency for power battery can be monitored in real time during the operation period of the vehicle, and the consistency for power battery can be evaluated with a more accurate method; additionally, visualized charts related to the consistency for power battery can be provided to the testing personnel or user of the vehicle in real time, so that the personnel can understand the performance of the vehicle more intuitively, thereby contributing to work such as test as well as check and acceptance for the power battery of the vehicle.

In addition, the basic principles of the present disclosure have been described above in conjunction with specific embodiments, but it is required to be pointed out that the merits, advantages, effects, and the like mentioned in the embodiments of the present disclosure are only examples rather than limitations, and these merits, advantages, effects, and the like cannot be considered as necessary for various embodiments of the present disclosure. Additionally, the specific details disclosed above are only for the purpose of illustration and easy understanding, but not for limitation, and the above details do not limit that the present disclosure must be implemented with the above specific details.

The block diagrams of the devices, equipment, apparatuses and systems involved in the embodiments of the present disclosure are only illustrative examples and are not intended to require or imply that they must be connected, arranged and configured in the manner shown in the block diagrams. As those skilled in the art will recognize, these devices, equipment, apparatuses and systems can be connected, arranged and configured in any manner. Words such as "including", "containing", "having" and the like are open words, which refer to "including but not limited to" and can be used interchangeably therewith. The terms of "or" and "and" as used herein refer to the term of "and/or" and can be used interchangeably therewith, unless otherwise indicated clearly by the context. The term of "such as" used herein refers to the phrase of "such as but not limited to" and can be used interchangeably therewith.

Additionally, as used herein, the "or" used in the enumeration of items starting with "at least one" indicates a separate enumeration, so that, for example, the enumeration of "at least one of A, B or C" means A or B or C, or AB or AC or BC, or ABC (i.e., A and B and C). In addition, the wording of "exemplary" does not mean that the described example is preferred or better than other examples.

It is also required to be pointed out that in the device and method of the present disclosure, various components or steps can be decomposed and/or recombined. Such decomposition and/or recombination should be regarded as schemes of the present disclosure.

For ordinary operators in the art, it can be understood that the entirety or any part of the method and device of the present disclosure can be implemented in hardware, firmware, software or their combination in any computing device (including processors, storage media, etc.) or network of computing devices. The hardware may be a general-purpose processor, a digital signal processor (DSP), an ASIC, a field programmable gate array (FPGA) or other programmable logic device (PLD), discrete gate or transistor logic, discrete hardware components, or any combination thereof designed to carry out the functions described herein. A general-purpose processor may be a microprocessor, but in alternative, the processor may be any commercially available processor, controller, microcontroller or state machine. A processor may also be implemented as a combination of computing devices, for example, a combination of a DSP and a microprocessor, a plurality of microprocessors, one or more microprocessors cooperating with a DSP core, or any other such configuration. Software can exist in any form of computer-readable tangible storage media. By way of example and not limitation, such computer-readable tangible storage media may include RAM, ROM, EEPROM, CD-ROM or other optical disk storage, magnetic disk storage or other magnetic storage devices or any other tangible media that can be used to carry or store desired program codes in the form of instructions or data structures and that can be accessed by a computer. As used herein, disc includes compact disc (CD), laser disc, optical disc, digital versatile disc (DVD), floppy disc and Blu-ray disc.

Various changes and alterations to the techniques described herein may be made without departing from the taught techniques defined by the appended claims. In addition, the scope of the claims of the present disclosure is not limited to the specific aspects of the above processes, machines, fabrications, compositions of events, means, methods and actions. The processes, machines, fabrications, compositions of events, means, methods or actions currently existing or to be developed later that perform substantially the same functions or achieve substantially the same results as those corresponding aspects described herein can be utilized. As such, the appended claims include such processes, machines, fabrications, compositions of events, means, methods or acts within their scope.

The above description of the disclosed aspects is provided to enable any operator in the art to make or use the present disclosure. Various modifications to such aspects will be obvious to those skilled in the art, and can be applied to other aspects without departing from the scope of the present disclosure. Therefore, the present disclosure is not intended to be limited to the aspects shown herein, but is to be accorded the widest scope consistent with the novel features disclosed herein.

The above description has been presented for the purpose of illustration and description. In addition, this description is not intended to limit the embodiments of the present disclosure to the forms disclosed herein. Although many example aspects and embodiments have been discussed above, those skilled in the art will recognize certain variations, modifications, changes, additions and sub-combinations thereof.

**Claims**

1. A method for estimating consistency for power battery, the power battery is composed of a plurality of cells and is configured to provide energy for a vehicle, and the method (S100) comprising:
   detecting operating voltages for each cell of the plurality of cells in real time during an operation period of the vehicle to obtain a first voltage dataset for the each cell (S101);
   **characterised by**:

   performing a first filtering process on the first voltage dataset to retain voltage data corresponding to operating currents less than a first threshold, such that a filtered second voltage dataset for the each cell is obtained (S102);
   calculating an energy score for the each cell based on the second voltage dataset (S103); and
   calculating a first consistency score for the power battery based on the calculated energy score for the each cell (S104).

2. The method of claim 1, wherein the obtaining a filtered second voltage dataset for the each cell further comprises:
   performing a second filtering process on the first voltage dataset to retain voltage data corresponding to a specific section of state of charge.

3. The method of claim 1, wherein the calculating an energy score for the each cell comprises:

   transforming the second voltage dataset into a frequency domain dataset with amplitude; and
   calculating the energy score for the each cell based on corresponding amplitudes of low-frequency components in the frequency domain dataset.

4. The method of any one of claims 1 to 3, wherein the calculating a first consistency score for the power battery comprises:

   performing a normalizing process on the calculated energy score for the each cell;
   determining a limit value according to statistical data of historical energy score, the limit value including at least one of an upper limit value and a lower limit value of the energy score;

   determining an energy score exceeding the limit value by a second threshold as an outlier; and
   calculating an Euclidean distance between the outlier and the exceeded limit value as the first consistency score.

5. The method of claim 4, wherein the calculating a first consistency score for the power battery further comprises:

   performing, using a principal component analysis method, a data dimension reduction process on the Euclidean distance of the outlier and an additional parameter during the operation period, and determining a value obtained by the data dimension reduction as the first consistency score; or
   calculating, using a machine learning-based model, the first consistency score for the power battery based on the Euclidean distance of the outlier and the additional parameter;
   wherein the additional parameter is selected from a group consisting of: state of charge of the power battery, usage time of the power battery, temperature of the power battery, resistance of the power battery, and current mileage of the vehicle.

6. A method for visualization of consistency for power battery, comprising:

   providing a first visualized representation of the energy score for the each cell as a function of a specific variable, based on the energy score calculated according to the method of any one of claims 1 to 5;
   wherein the specific variable is a variable related to mileage of the vehicle or usage time of the power battery.

7. The method for visualization of claim 6, further comprising:

   displaying a first decision line in the first visualized representation, wherein the first decision line is determined according to statistical data of historical energy score; and
   indicating a cell corresponding to a function exceeding the first decision line by a third threshold as an abnormal cell.

8. A method for estimating vehicle level-based consistency for power battery, comprising:

   calculating, for each vehicle of a plurality of vehicles using the same power batteries, the first consistency score for the power battery of the each vehicle, respectively, according to the method of any one of claims 1 to 5; and calculating a vehicle level-based second consistency score for power battery based on the first consistency score for the power battery of the each vehicle.

9. A method for visualization of vehicle level-based consistency for power battery, comprising:

providing a second visualized representation of the first consistency score for the power battery of the each vehicle as a function of a specific variable, based on the first consistency score for the power battery of the each vehicle calculated according to the method of claim 8; wherein the specific variable is a variable related to mileage of the each vehicle or usage time of the power battery of the each vehicle.

10. The method of claim 9, further comprising:

displaying a second decision line in the second visualized representation, wherein the second decision line is determined according to statistical data of historical second consistency score; and indicating a vehicle corresponding to a function exceeding the second decision line by a fourth threshold as an abnormal vehicle.

11. An apparatus (600) for estimating consistency for power battery which is composed of a plurality of cells and is configured to provide energy for a vehicle, the apparatus comprising:

a processor (610); and a memory (620) having stored computer program instructions therein, wherein the computer program instructions, when executed by the processor, cause the processor to perform a method of any one of claims 1-5.

12. The apparatus of claim 11, further comprising a device (630) for visualizing the consistency for power battery, the device being configured to:

provide a first visualized representation of the energy score for the each cell as a function of a specific variable based on the calculated energy score, wherein the specific variable is a variable related to mileage of the vehicle or usage time of the power battery; display a first decision line in the first visualized representation, wherein the first decision line is determined according to statistical data of historical energy score; and indicate a cell corresponding to a function exceeding the first decision line by a third threshold as an abnormal cell.

13. An apparatus (600) for estimating vehicle level-based consistency for power battery, the apparatus comprising:

a processor (610); and a memory (620) having stored computer program instructions therein, wherein the computer program instructions, when executed by the processor, cause the processor to:

calculate, for each vehicle of a plurality of vehicles using the same power batteries, the first consistency score for the power battery of the each vehicle, respectively, according to the method of any one of claims 1-5; and calculate a vehicle level-based second consistency score for power battery based on the first consistency score for the power battery of the each vehicle.

14. The apparatus of claim 13, further comprising a device for visualizing the consistency for power battery, wherein the device for visualizing the consistency for power battery is configured to:

provide a second visualized representation of the first consistency score for the power battery of the each vehicle as a function of a specific variable based on the calculated first consistency score for the power battery of the each vehicle, wherein the specific variable is a variable related to mileage of the each vehicle or usage time of the power battery of the each vehicle; display a second decision line in the second visualized representation, wherein the second decision line is determined according to statistical data of historical second consistency score; and indicate a vehicle corresponding to a function exceeding the second decision line by a fourth threshold as an abnormal vehicle.

15. A computer-readable storage medium having stored computer program instructions thereon, wherein the computer program instructions, when executed by a processor, implement the method of any one of claims 1 to 10.

**Patentansprüche**

1. Verfahren zum Schätzen der Konsistenz einer Leistungsbatterie, wobei die Leistungsbatterie aus einer Vielzahl von Zellen besteht und dazu ausgelegt ist, ein Fahrzeug mit Energie zu versorgen, und wobei das Verfahren (S100) Folgendes aufweist:

Erfassen der Betriebsspannungen für jede Zelle der Vielzahl von Zellen in Echtzeit während einer Betriebsphase des Fahrzeugs, um einen ersten Spannungsdatensatz für jede Zelle zu erhalten (S101);
**gekennzeichnet durch**:

Durchführen eines ersten Filtervorgangs auf den ersten Spannungsdatensatz, um Spannungsdaten beizubehalten, die Betriebsströmen unterhalb eines ersten Schwellenwerts entsprechen, sodass für jede Zelle ein gefilterter zweiter Spannungsdatensatz erhalten wird (S102);
Berechnen eines Energiewerts für jede Zelle auf der Grundlage des zweiten Spannungsdatensatzes (S103); und
Berechnen eines ersten Konsistenzwerts für die Leistungsbatterie auf der Grundlage des berechneten Energiewerts für jede Zelle (S104).

2. Verfahren nach Anspruch 1, wobei das Erhalten eines gefilterten zweiten Spannungsdatensatzes für jede Zelle darüber hinaus Folgendes aufweist: Durchführen eines zweiten Filtervorgangs auf den ersten Spannungsdatensatz, um Spannungsdaten beizubehalten, die einem bestimmten Abschnitt des Ladezustands entsprechen.

3. Verfahren nach Anspruch 1, wobei das das Berechnen eines Energiewerts für jede Zelle Folgendes aufweist:

Umwandeln des zweiten Spannungsdatensatzes in einen Frequenzbereichsdatensatz mit Amplitude; und
Berechnen des Energiewerts für jede Zelle auf der Grundlage der entsprechenden Amplituden der Niederfrequenzkomponenten im Frequenzbereichsdatensatz.

4. Verfahren nach einem der Ansprüche 1 bis 3, wobei das Berechnen eines ersten Konsistenzwerts für die Leistungsbatterie Folgendes aufweist:

Durchführen eines Normalisierungsprozesses an dem berechneten Energiewert für jede Zelle;
Bestimmen eines Grenzwerts auf der Grundlage statistischer Daten des historischen Energiewerts, wobei der Grenzwert mindestens einen oberen Grenzwert und/oder einen unteren Grenzwert des Energiewerts aufweist;

Bestimmen eines Energiewerts, der den Grenzwert um einen zweiten Schwellenwert überschreitet, als Ausreißer; und
Berechnen eines euklidischen Abstands zwischen dem Ausreißer und dem überschrittenen Grenzwert als ersten Konsistenzwert.

5. Verfahren nach Anspruch 4, wobei das Berechnen eines ersten Konsistenzwerts für die Leistungsbatterie darüber hinaus Folgendes aufweist:

Durchführen eines Verfahrens zur Reduzierung der Datenausmaße unter Verwendung einer Hauptkomponentenanalyse auf den euklidischen Abstand des Ausreißers und einen zusätzlichen Parameter während der Betriebsphase sowie Bestimmen eines durch die Reduzierung der Datenausmaße erhaltenen Werts als ersten Konsistenzwert; oder
Berechnen des ersten Konsistenzwerts für die Leistungsbatterie mithilfe eines auf maschinellem Lernen basierenden Modells, basierend auf dem euklidischen Abstand des Ausreißers und dem zusätzlichen Parameter;
wobei der zusätzliche Parameter aus einer Gruppe ausgewählt wird, die aus folgenden Größen besteht: Ladezustand der Leistungsbatterie, Nutzungsdauer der Leistungsbatterie, Temperatur der Leistungsbatterie, Widerstand der Leistungsbatterie und aktuelle Kilometerleistung des Fahrzeugs.

6. Verfahren zum Visualisieren der Konsistenz einer Leistungsbatterie, das Folgendes aufweist:

Bereitstellen einer ersten visuellen Darstellung des Energiewerts für jede Zelle als Funktion einer spezifischen Variablen, basierend auf dem Energiewert, der gemäß dem Verfahren nach einem der Ansprüche 1 bis 5 berechnet wurde;
wobei die spezifische Variable eine Variable ist, die sich auf die Laufleistung des Fahrzeugs oder die Nutzungsdauer der Leistungsbatterie bezieht.

7. Verfahren zum Visualisieren nach Anspruch 6, das darüber hinaus Folgendes aufweist:

Anzeigen einer ersten Entscheidungslinie in der ersten visualisierten Darstellung, wobei die erste Entscheidungslinie anhand statistischer Daten des historischen Energiewerts bestimmt wird; und
Kennzeichnen einer Zelle, die einer Funktion entspricht, die die erste Entscheidungslinie um einen dritten Schwellenwert überschreitet, als abnormale Zelle.

**8.** Verfahren zum Schätzen der auf der Fahrzeugebene basierenden Konsistenz einer Leistungsbatterie, das Folgendes aufweist:

Berechnen des ersten Konsistenzwerts für die Leistungsbatterie jedes Fahrzeugs für jedes Fahrzeug einer Vielzahl von Fahrzeugen, die dieselben Leistungsbatterien verwenden, gemäß dem Verfahren nach einem der Ansprüche 1 bis 5; und
Berechnen eines zweiten Konsistenzwerts auf Fahrzeugebene für die Leistungsbatterie auf der Grundlage des ersten Konsistenzwerts für die Leistungsbatterie jedes Fahrzeugs.

**9.** Verfahren zum Visualisieren der auf der Fahrzeugebene basierenden Konsistenz einer Leistungsbatterie, das Folgendes aufweist:

Bereitstellen einer zweiten visuellen Darstellung des ersten Konsistenzwerts für die Leistungsbatterie jedes Fahrzeugs als Funktion einer spezifischen Variablen, basierend auf dem ersten Konsistenzwert für die Leistungsbatterie jedes Fahrzeugs, der gemäß dem Verfahren nach Anspruch 8 berechnet wurde;
wobei die spezifische Variable eine Variable ist, die sich auf die Laufleistung jedes Fahrzeugs oder die Nutzungsdauer der Leistungsbatterie jedes Fahrzeugs bezieht.

**10.** Verfahren nach Anspruch 9, das darüber hinaus Folgendes aufweist:

Anzeigen einer zweiten Entscheidungslinie in der zweiten visualisierten Darstellung, wobei die zweite Entscheidungslinie anhand statistischer Daten des historischen zweiten Konsistenzwerts bestimmt wird; und
Kennzeichnen eines Fahrzeugs, das einer Funktion entspricht, die die zweite Entscheidungslinie um einen vierten Schwellenwert überschreitet, als abnormales Fahrzeug.

**11.** Vorrichtung (600) zum Schätzen der Konsistenz einer Leistungsbatterie, die aus einer Vielzahl von Zellen besteht und dazu ausgelegt ist, ein Fahrzeug mit Energie zu versorgen, wobei die Vorrichtung Folgendes aufweist:

einen Prozessor (610); und
einen Speicher (620) mit darin gespeicherten Computerprogrammanweisungen,
wobei die Computerprogrammanweisungen, wenn sie vom Prozessor ausgeführt werden, bewirken, dass der Prozessor ein Verfahren gemäß einem der Ansprüche 1-5 durchführt.

**12.** Vorrichtung nach Anspruch 11, die darüber hinaus eine Einrichtung (630) zum Visualisieren der Konsistenz für eine Leistungsbatterie aufweist, wobei die Einrichtung ausgelegt ist zum:

Bereitstellen einer ersten visualisierten Darstellung des Energiewerts für jede Zelle als Funktion einer spezifischen Variablen auf der Grundlage des berechneten Energiewerts, wobei die spezifische Variable eine Variable ist, die sich auf die Laufleistung des Fahrzeugs oder die Nutzungsdauer der Leistungsbatterie bezieht;
Anzeigen einer ersten Entscheidungslinie in der ersten visualisierten Darstellung, wobei die erste Entscheidungslinie anhand statistischer Daten des historischen Energiewerts bestimmt wird; und
Kennzeichnen einer Zelle, die einer Funktion entspricht, die die erste Entscheidungslinie um einen dritten Schwellenwert überschreitet, als abnormale Zelle.

**13.** Vorrichtung (600) zum Schätzen der auf der Fahrzeugebene basierenden Konsistenz einer Leistungsbatterie, wobei die Vorrichtung Folgendes aufweist:

einen Prozessor (610); und
einen Speicher (620) mit darin gespeicherten Computerprogrammanweisungen,
wobei die Computerprogrammanweisungen beim Ausführen durch den Prozessor den Prozessor zu Folgendem veranlassen:

Berechnen des ersten Konsistenzwerts für die Leistungsbatterie jedes Fahrzeugs für jedes Fahrzeug einer Vielzahl von Fahrzeugen, die dieselben Leistungsbatterien verwenden, gemäß dem Verfahren nach einem der Ansprüche 1-5; und
Berechnen eines zweiten Konsistenzwerts auf Fahrzeugebene für die Leistungsbatterie auf der Grundlage des ersten Konsistenzwerts für die Leistungsbatterie jedes Fahrzeugs.

**14.** Vorrichtung nach Anspruch 13, die darüber hinaus eine Einrichtung zum Visualisieren der Konsistenz der Leistungsbatterie aufweist, wobei die Einrichtung zum Visualisieren der Konsistenz der Leistungsbatterie ausgelegt ist zum:

Bereitstellen einer zweiten visuellen Darstellung des ersten Konsistenzwerts für die Leistungsbatterie jedes Fahrzeugs als Funktion einer spezifischen Variablen, basierend auf dem berechneten ersten Konsistenzwert für die Leistungsbatterie jedes Fahrzeugs, wobei die spezifische Variable eine Variable ist, die sich auf die Laufleistung jedes Fahrzeugs oder die Nutzungsdauer der Leistungsbatterie jedes Fahrzeugs bezieht;

Anzeigen einer zweiten Entscheidungslinie in der zweiten visualisierten Darstellung, wobei die zweite Entscheidungslinie anhand statistischer Daten des historischen zweiten Konsistenzwerts bestimmt wird; und

Kennzeichnen eines Fahrzeugs, das einer Funktion entspricht, die die zweite Entscheidungslinie um einen vierten Schwellenwert überschreitet, als abnormales Fahrzeug.

**15.** Computerlesbares Speichermedium mit darauf gespeicherten Computerprogrammanweisungen, wobei die Computerprogrammanweisungen, wenn sie durch einen Prozessor ausgeführt werden, das Verfahren nach einem der Ansprüche 1 bis 10 implementieren.

## Revendications

**1.** Procédé pour estimer une homogénéité pour une batterie électrique, la batterie électrique est composée d'une pluralité de cellules et est configurée pour fournir de l'énergie pour un véhicule, et le procédé (S100) comprenant :

le fait de détecter des tensions de fonctionnement pour chaque cellule de la pluralité de cellules en temps réel durant une période de fonctionnement du véhicule pour obtenir un premier ensemble de données de tension pour chaque cellule (S101) ;
**caractérisé par** les faits :

de réaliser un premier processus de filtrage sur le premier ensemble de données de tension pour garder des données de tension correspondant à des courants de fonctionnement inférieurs à un premier seuil, de manière telle qu'un second ensemble filtré de données de tension pour chaque cellule est obtenu (S102) ;
de calculer une note d'évaluation d'énergie pour chaque cellule sur la base du second ensemble de données de tension (S103) ; et
de calculer une première note d'évaluation d'homogénéité pour la batterie électrique sur la base de la note d'évaluation d'énergie calculée pour chaque cellule (S104).

**2.** Procédé de la revendication 1, dans lequel le fait d'obtenir un second ensemble filtré de données de tension pour chaque cellule comprend en outre :
le fait de réaliser un second processus de filtrage sur le premier ensemble de données de tension pour garder des données de tension correspondant à une section spécifique d'état de charge.

**3.** Procédé de la revendication 1, dans lequel le fait de calculer une note d'évaluation d'énergie pour chaque cellule comprend les faits :

de transformer le second ensemble de données de tension en un ensemble de données de domaine fréquentiel avec amplitude ; et
de calculer la note d'évaluation d'énergie pour chaque cellule sur la base d'amplitudes correspondantes de composantes basse-fréquence dans l'ensemble de données de domaine fréquentiel.

**4.** Procédé de l'une quelconque des revendications 1 à 3, dans lequel le fait de calculer une première note d'évaluation d'homogénéité pour la batterie électrique comprend les faits :

de réaliser un processus de normalisation sur la note d'évaluation d'énergie calculée pour chaque cellule ;
de déterminer une valeur limite selon des données statistiques de note d'évaluation d'énergie historique, la valeur limite incluant au moins une d'une valeur limite supérieure et d'une valeur limite inférieure de la note d'évaluation d'énergie ;
de déterminer qu'une note d'évaluation d'énergie dépassant la valeur limite selon un deuxième seuil est une valeur aberrante ; et
de calculer une distance euclidienne entre la valeur aberrante et la valeur limite dépassée en tant que première note d'évaluation d'homogénéité.

**5.** Procédé de la revendication 4, dans lequel le fait de calculer une première note d'évaluation d'homogénéité pour la batterie électrique comprend en outre les faits :

de réaliser, en utilisant une méthode d'analyse en composantes principales, un processus de réduction de dimension de données sur la distance euclidienne de la valeur aberrante et d'un paramètre supplémentaire durant la période de fonctionnement, et de déterminer qu'une valeur obtenue par la réduction de dimension de données est une première note d'évaluation d'homogénéité ; ou
de calculer, en utilisant un modèle à base d'apprentissage machine, la première note d'évaluation d'homogénéité pour la batterie électrique sur la base de la distance euclidienne de la valeur aberrante et du paramètre supplémentaire ;

dans lequel le paramètre supplémentaire est sélectionné parmi un groupe constitué de : état de charge de la batterie électrique, temps d'utilisation de la batterie électrique, température de la batterie électrique, résistance de la batterie électrique, et kilométrage actuel du véhicule.

6. Procédé pour visualisation d'homogénéité pour batterie électrique, comprenant :

le fait de fournir une première représentation visualisée de la note d'évaluation d'énergie pour chaque cellule en fonction d'une variable spécifique, sur la base de la note d'évaluation d'énergie calculée selon le procédé de l'une quelconque des revendications 1 à 5 ;
dans lequel la variable spécifique est une variable connexe à un kilométrage du véhicule ou à un temps d'utilisation de la batterie électrique.

7. Procédé pour visualisation de la revendication 6, comprenant en outre les faits :

d'afficher une première ligne de décision dans la première représentation visualisée, dans lequel la première ligne de décision est déterminée selon des données statistiques de note d'évaluation d'énergie historique ; et
d'indiquer qu'une cellule correspondant à une fonction dépassant la première ligne de décision selon un troisième seuil est une cellule anormale.

8. Procédé pour estimer une homogénéité à base de niveau de véhicule pour une batterie électrique, comprenant les faits :

de calculer, pour chaque véhicule d'une pluralité de véhicules utilisant les mêmes batteries électriques, la première note d'évaluation d'homogénéité pour la batterie électrique de chaque véhicule, respectivement, selon le procédé de l'une quelconque des revendications 1 à 5 ; et
de calculer une seconde note d'évaluation à base de niveau de véhicule d'homogénéité pour batterie électrique sur la base de la première note d'évaluation d'homogénéité pour la batterie électrique de chaque véhicule.

9. Procédé pour visualisation d'homogénéité à base de niveau de véhicule pour batterie électrique, comprenant les faits :

de fournir une seconde représentation visualisée de la première note d'évaluation d'homogénéité pour la batterie électrique de chaque véhicule en fonction d'une variable spécifique, sur la base de la première note d'évaluation d'homogénéité pour la batterie électrique de chaque véhicule calculée selon le procédé de la revendication 8 ;
dans lequel la variable spécifique est une variable connexe à un kilométrage de chaque véhicule ou à un temps d'utilisation de la batterie électrique de chaque véhicule.

10. Procédé de la revendication 9, comprenant en outre les faits :

d'afficher une seconde ligne de décision dans la seconde représentation visualisée, dans lequel la seconde ligne de décision est déterminée selon des données statistiques de seconde note d'évaluation d'homogénéité historique ; et
d'indiquer qu'un véhicule correspondant à une fonction dépassant la seconde ligne de décision selon un quatrième seuil est un véhicule anormal.

11. Appareil (600) pour estimer une homogénéité pour une batterie électrique qui est composée d'une pluralité de cellules et est configurée pour fournir de l'énergie pour un véhicule, l'appareil comprenant :

un processeur (610) ; et
une mémoire (620) dans laquelle sont stockées des instructions de programme d'ordinateur, dans lequel les instructions de programme d'ordinateur, lorsqu'elles sont exécutées par le processeur, amènent le processeur à réaliser un procédé de l'une quelconque des revendications 1 à 5.

12. Appareil de la revendication 11, comprenant en outre un dispositif (630) pour visualiser l'homogénéité pour une batterie électrique, le dispositif étant configuré pour :

fournir une première représentation visualisée de la note d'évaluation d'énergie pour chaque cellule en fonction d'une variable spécifique sur la base de la note d'évaluation d'énergie calculée, dans lequel la variable spécifique est une variable connexe à un kilométrage du véhicule ou à un temps d'utilisation de la batterie électrique ;
afficher une première ligne de décision dans la première représentation visualisée, dans lequel la première ligne de décision est déterminée selon des données statistiques de note d'évaluation d'énergie historique ; et
indiquer qu'une cellule correspondant à une fonction dépassant la première ligne de décision selon un troisième seuil est une cellule anormale.

**13.** Appareil (600) pour estimer une homogénéité à base de niveau de véhicule pour une batterie électrique, l'appareil comprenant :

un processeur (610) ; et
une mémoire (620) dans laquelle sont stockées des instructions de programme d'ordinateur, dans lequel les instructions de programme d'ordinateur, lorsqu'elles sont exécutées par le processeur, amènent le processeur à :

calculer, pour chaque véhicule d'une pluralité de véhicules utilisant les mêmes batteries électriques, la première note d'évaluation d'homogénéité pour la batterie électrique de chaque véhicule, respectivement, selon le procédé de l'une quelconque des revendications 1 à 5 ; et
calculer une seconde note d'évaluation à base de niveau de véhicule d'homogénéité pour batterie électrique sur la base de la première note d'évaluation d'homogénéité pour la batterie électrique de chaque véhicule.

**14.** Appareil de la revendication 13, comprenant en outre un dispositif pour visualiser l'homogénéité pour une batterie électrique, dans lequel le dispositif pour visualiser l'homogénéité pour batterie électrique est configuré pour :

fournir une seconde représentation visualisée de la première note d'évaluation d'homogénéité pour la batterie électrique de chaque véhicule en fonction d'une variable spécifique sur la base de la première note d'évaluation d'homogénéité calculée pour la batterie électrique de chaque véhicule, dans lequel la variable spécifique est une variable connexe à un kilométrage de chaque véhicule ou à un temps d'utilisation de la batterie électrique de chaque véhicule ;
afficher une seconde ligne de décision dans la seconde représentation visualisée, dans lequel la seconde ligne de décision est déterminée selon des données statistiques de seconde note d'évaluation d'homogénéité historique ; et
indiquer qu'un véhicule correspondant à une fonction dépassant la seconde ligne de décision selon un quatrième seuil est un véhicule anormal.

**15.** Support de stockage lisible par ordinateur sur lequel sont stockées des instructions de programme d'ordinateur, dans lequel les instructions de programme d'ordinateur, lorsqu'elles sont exécutées par un processeur, mettent en œuvre le procédé de l'une quelconque des revendications 1 à 10.

**100**

| S101 | Detecting operating voltages for each cell of the plurality of cells in real time during a operation period of the vehicle to obtain a first voltage dataset for the each cell |
| S102 | Performing a filtering process on the obtained first voltage dataset , such that a filtered second voltage dataset is obtained |
| S103 | Calculating an energy score for the each cell based on the filtered second voltage dataset |
| S104 | Calculating a first consistency score for the power battery based on the calculated energy score for the each cell |

Fig. 1

Fig. 2

Fig. 3

Fig. 4

Fig. 5

Fig. 6

**EP 4 530 650 B1**

**Patent documents cited in the description**

- CN 102540098 A